# EUROPÄISCHE PATENTSCHRIFT

(11) **EP 0 881 866 B1**
(45) Veröffentlichungstag und Bekanntmachung des Hinweises auf die Patenterteilung: **27.09.2000**
(21) Anmeldenummer: 98102075.3
(22) Anmeldetag: 06.02.1998
(51) Int. Cl.: H05K 1/02

(54) **Steuergerät**
Control device
Dispositif de commande

(30) Priorität: 28.05.1997 DE 19722357
(43) Veröffentlichungstag der Anmeldung: 02.12.1998
(73) Patentinhaber: ROBERT BOSCH GMBH, 70442 Stuttgart (DE)
(72) Erfinder: Lochbrunner, Eduard, 71282 Hemmingen (DE); Schmid, Roldand, 70599 Stuttgart (DE); Schweinbenz, Jochen, 70469 Stuttgart (DE); Schiefer, Peter, 74199 Untergruppenbach (DE)

(56) Entgegenhaltungen:
- EP-A- 0 727 931

## Beschreibung

Die Erfindung geht von einem Steuergerät entsprechend der Gattung des Anspruchs 1 aus. Derartige Steuergeräte, wie sie beispielsweise aus der DE 40 09 445 A1 bekannt sind, bestehen aus einem mehrteiligen Gehäuse, in dessen Innenraum ein mit elektronischen Bauelementen bestückter Schaltungsträger angeordnet ist. Zur Abführung der Verlustwärme, die im Betrieb des Steuergeräts, insbesondere von den Leistungsbauelementen erzeugt wird, werden separate Kühlkörper eingesetzt.

Aus dem GM 92 006 24.8 ist es desweiteren bekannt, auch das Gehäuse eines Steuergeräts als Kühlfläche zu nutzen. Um die Verlustwärme mit einem geringen thermischen Widerstand abzuführen, sind die Leistungsbauelemente im Randbereich des Schaltungsträgers angeordnet, der hierzu in ein speziell ausgeformtes Gehäuse eingespannt ist. Der Schaltungsträger ist zudem mit einer wärmeleitenden Schicht in Form einer Kupferkaschierung versehen. Die Verlustleistung, insbesondere von neuartigen Leistungsbauelementen, ist jedoch derart groß, daß sie auf diese Weise nur unzureichend abgeleitet werden kann.

Ein geringer thermischer Widerstand zwischen dem Schaltungsträger und dem Gehäuse kann auch durch auf der Unterseite eines Schaltungsträgers ausgebildete Wärmeableitflächen dem Gehäuse zugeführt werden. Zur Wärmeübertragung von den Leistungsbauelementen auf diese Wärmeableitflächen sind jedoch aufwendig zu fertigende thermische Durchkontaktierungen erforderlich.

Die beschriebenen Arten der Wärmeabführung haben den Nachteil, daß sie neben den möglichen Positionen für die Verlustwärme erzeugenden Bauelemente auf dem Schaltungsträger die zur Verfügung stehende Fläche zur Ausbildung der Schaltung einschränken. Dies kann zusammen mit stetig ansteigenden Funktionsanforderungen an die Steuergeräte, die meist mit einer zunehmenden Anzahl von elektronischen Bauelementen einhergehen, zu räumlichen oder thermischen Schwierigkeiten führen, die im Extremfall den Ausfall des Steuergeräts bewirken können. Außerdem sind diese Arten der Wärmeabführung relativ aufwendig und teuer herzustellen.

### Vorteile der Erfindung

Demgegenüber weist ein erfindungsgemäßes Steuergerät mit den kennzeichnenden Merkmalen des Anspruchs 1 den Vorteil einer verbesserten und preisgünstig herzustellenden Wärmeabführung auf. Derartige Steuergeräte eignen sich für einen erhöhten elektronischen Leistungsbereich.

Ein niedriger thermische Widerstand wird unter anderem dadurch erreicht, daß die Leistungsbauelemente auf der einen dem Gehäuse zugewandten Seite eines Schaltungsträgers plaziert, in raumsparender Flip/Chip-Technik ausgebildet und vollständig von einem Wärmeleitkleber umschlossen sind.

Dadurch ist der Schaltungsträger großflächig thermisch und mechanisch an das Gehäuse angebunden. Beide Seiten des Schaltungsträgers sind dadurch mit Bauelementen bestückbar, so daß die Anordnung der Leistungsbauelemente relativ frei wählbar ist. Neben einem Gewinn an nutzbarer Substratfläche kann die elektrische Kontaktierung der Leistungsbauelemente mit nur verhältnismäßig kurzen Leitungswegen erfolgen, so daß gleichzeitig mit einem kompakten und gegenüber Erschütterungen robustem Aufbau des Steuergeräts dessen elektromagnetische Verträglichkeit erhöht wird. Infolge der flexibleren Anordnung der Bauelemente sind derart aufgebaute Steuergeräte leichter an Kundenwünsche anpaßbar. Zudem zeichnen sich diese Steuergeräte durch ihre kostengünstige Herstellung aus, die auf bestehenden Fertigungseinrichtungen ausgeführt werden kann. Eine besonders wirksame Abfuhr von Verlustwärme wird erreicht, wenn die als Flip/Chip ausgebildeten Leistungsbauelemente auf ihrer vom Schaltungsträger abgewandten, potentialfreien Seite mit einem Wärmeverteiler ausgestattet sind. Der metallische und mit dem Leistungsbauelement vorzugsweise verlötete Wärmeverteiler wird ebenfalls von der wärmeableitenden Masse umschlossen. Der Wärmeverteiler erhöht die für eine Wärmeabfuhr zur Verfügung stehende Oberfläche eines Leistungsbauteils deutlich, ohne die o.g. Vorteile der Flip/Chip-Technik einzuschränken. Ist der das Leistungsbauelement überragende Wärmeverteiler mit Abkröpfungen in Richtung des Schaltungsträgers versehen, so können dadurch die Leistungsbauelemente zusätzlich auch vor zu hohen mechanischen Belastungen geschützt werden.

Weitere Vorteile oder vorteilhafte Weiterbildungen der Erfindung ergeben sich aus den Unteransprüchen oder der schreibung.

### Zeichnung

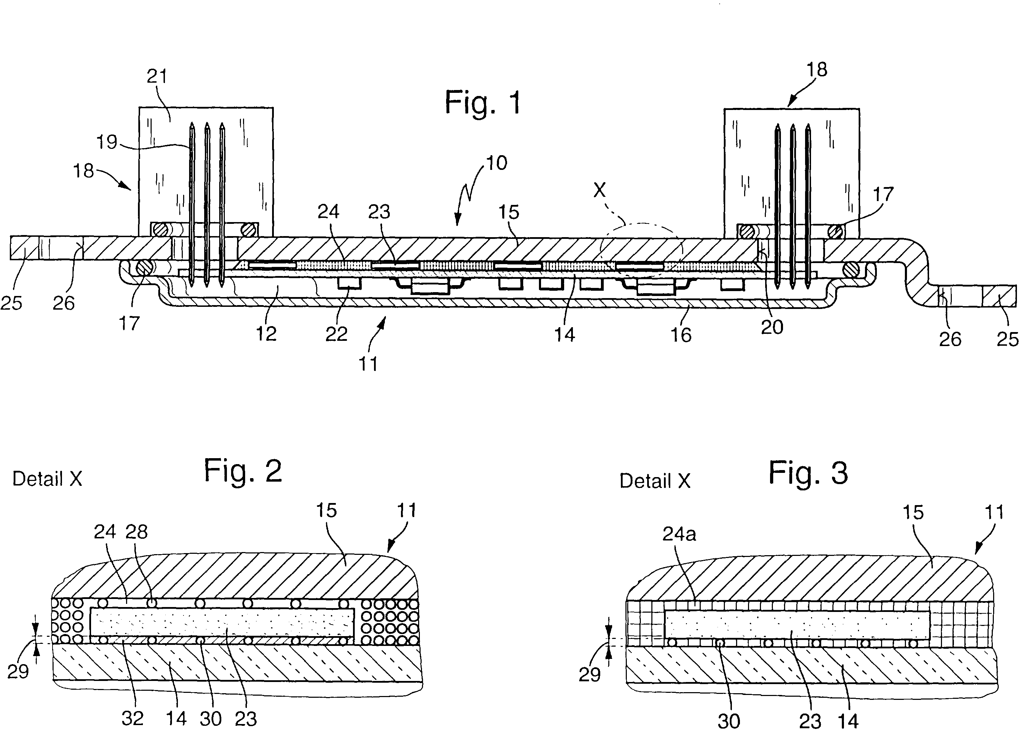

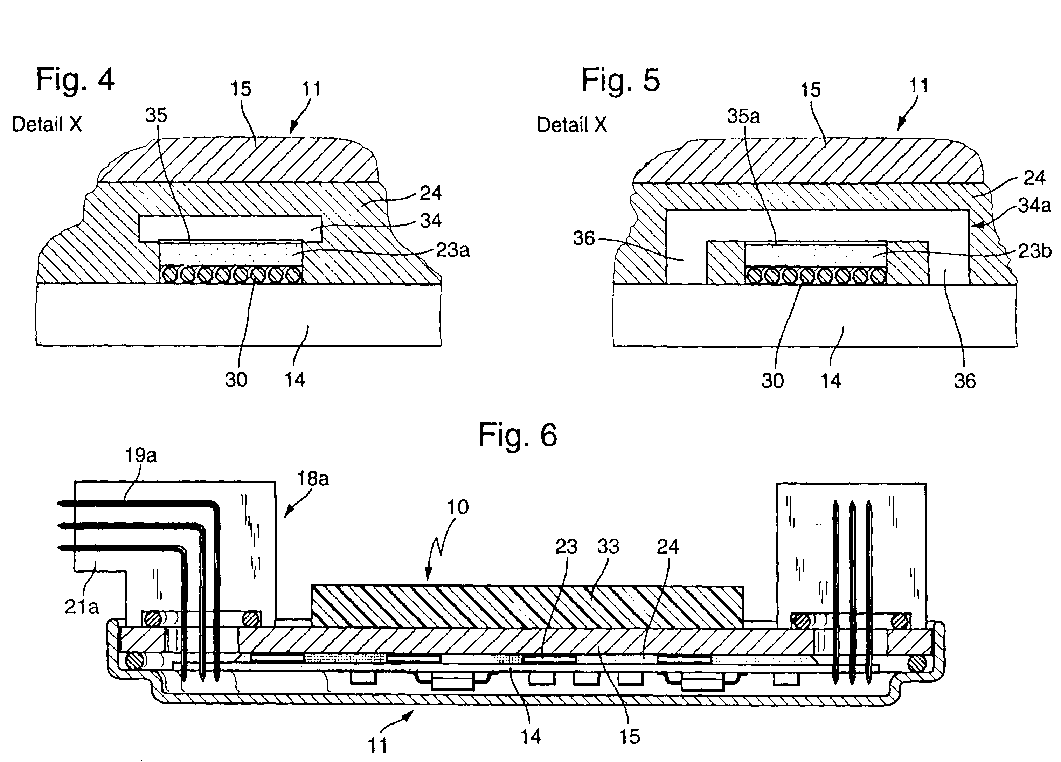

Ein Ausführungsbeispiel der Erfindung ist in der Zeichnung dargestellt und in der nachfolgenden Beschreibung näher erläutert. Figur 1 zeigt einen Längsschnitt durch ein erfindungsgemäßes Steuergerät, in den Figuren 2 bis 5 ist jeweils eine Ausführungsvariante des Details X nach Figur 1 vergrößert dargestellt und Figur 6 zeigt ein in Bezug auf die Wärmeableitung zur Umgebung weitergebildetes Steuergerät.

### Beschreibung des Ausführungsbeispiels

Ein gemäß Figur 1 ausgebildetes, elektronisches Steuergerät 10 weist ein Gehäuse 11 auf, in dessen Innenraum 12 ein Schaltungsträger 14 angeordnet ist. Als Schaltungsträger 14 können z.B. Leiterplatten, Folien oder Leiterplatten mit Mikrovias, wie beispielsweise Dycrostate, verwendet werden. Das Gehäuse 11 des Steuergeräts 10 ist exemplarisch zweiteilig ausgebildet und besteht aus einer ebenen Grundplatte 15 über die haubenförmig ein Deckel 16 gestülpt ist. Die aus einem wärmeleitenden Material, beispielsweise Stahlblech oder Aluminium, bestehende Grundplatte 15 und der Deckel 16 sind auf nicht dargestellte Weise, zum Beispiel mittels einer Schraub-, Rast-, Klemm- oder ähnlichen Verbindungsmethoden miteinander verbunden. Dichtelemente 17 zwischen der Grundplatte 15 und dem Deckel 16 dichten den Innenraum 12 nach außen ab. An beiden Enden der Grundplatte 15 ist jeweils eine Steckeranordnung 18 angeordnet, deren Kontaktstifte 19 durch Durchbrüche 20 in der Grundplatte 15 in den Innenraum 12 des Steuergeräts 10 hineinragen und dort zur Signalübertragung mit dem Schaltungsträger 14 leitend verbunden sind. Selbstverständlich können in anderen Anwendungsfällen mehrere beliebig verteilte Steckeranordnungen 18 bzw. auch nur eine einzelne Steckeranordnung 18 ausgebildet sein. Auch die Durchbrüche 20 in der Grundplatte 15 sind mit Hilfe von Dichtelementen 17 zur Umgebung hin abgedichtet. Die Kontaktstifte 19 der Steckeranordnungen 18 sind mit Ausnahme ihrer beiden Enden vom Kunststoffmaterial des Steckergehäuses 21 der Steckeranordnung 18 umschlossen, so daß der Innenraum 12 auch bezüglich dieser Stelle von der Umgebung abgeschlossen ist. Der in diesem Innenraum 12 angeordnete Schaltungsträger 14 ist beidseitig mit elektronischen Bauelementen 22, 23 bestückt, die in der Zeichnung nur vereinfacht dargestellt sind. Die Anordnung der Bauelemente 22, 23 auf dem Schaltungsträger 14 ist dabei so gewählt, daß sämtliche Verlustwärme erzeugenden Leistungsbauelemente 23 auf der der Grundplatte 15 zugewandten Seite des Schaltungsträgers 14 liegen. Zeichnerisch nicht dargestellt ist, daß diese Verlustwärme erzeugenden Leistungsbauelemente 23 integrierte Schaltkreise sind, die in der aus der Hybridfertigung bekannten Flip/Chip-Technik ausgebildet und entsprechend mit dem Schaltungsträger 14 kontaktiert sind. Die Flip-Chip-Technik vermindert neben der Baugröße dieser Leistungsbauelemente 23 auch den zu ihrer elektrischen Kontaktierung erforderlichen Platzbedarf auf dem Schaltungsträger 14. Die Verlustwärme erzeugenden Leistungsbauelemente 23 sind in eine wärmeableitende Masse 24 eingebettet, die den Zwischenraum zwischen dem Schaltungsträger 14 und der Grundplatte 15 vollständig und großflächig ausfüllt. Die wie ein Kleber wirkende wärmeableitende Masse 24 koppelt den Schaltungsträger 14 damit direkt thermisch und mechanisch an die Grundplatte 15 des Steuergeräts 10 an. Weitere Bauteile oder Arbeitsgänge zur Befestigung des Schaltungsträgers 14 im Gehäuse 11 sind demnach nicht notwendig. Die wärmeableitende Masse 24 leitet die von den Leistungsbauelementen 23 erzeugte Verlustwärme bei einem relativ geringen thermischen Widerstand an die Grundplatte 15 ab, von wo aus die Verlustwärme abhängig vom Einbaufall des Steuergeräts 10 an angrenzende Bauteile oder an die Umgebung abgeführt wird. Diese Art der Wärmeableitung erlaubt vor allem aufgrund des dabei entgegenstehenden geringen thermischen Widerstands ein für hohe elektrische Leistungsbereiche einsetzbares Steuergerät 10. Dieses Steuergerät 10 ist wegen der Klebeverbindung zwischen dem Schaltungsträger 14 und dem Gehäuse 11 zudem relativ unempfindlich gegen Vibrationen und Schwingungen und baut, weil beide Seiten des Schaltungsträgers 14 mit elektronischen Bauelementen 22,23 bestückt werden können, ohne daß Überhitzungsprobleme entstehen, relativ kompakt. Zudem erlaubt es die wärmeableitende Masse 24, daß nahezu jede beliebige Stelle des Schaltungsträgers 14 mit dem Gehäuse 11 verbunden werden kann, so daß die Plazierung der Leistungsbauelemente 23 in weiten Bereichen frei wählbar ist. Dadurch werden auch die Möglichkeiten zur Positionierung der Steckeranordnungen 18 erweitert, so daß das Steuergerät 10 relativ leicht an diesbezügliche Wünsche des Anwenders anpaßbar ist. Für die Leistungsbauelemente 23 ergibt sich aus der Flexibilität ihrer Anordnung, daß sie verhältnismäßig nah zur Steckeranordnung 18 plaziert werden können. Eine steckernahe Anordnung ist deshalb vorteilhaft, weil die nicht gezeichneten elektrischen Verbindungsleitungen zu diesen Leistungsbauelementen 23 dadurch relativ kurz ausgeführt werden können. Derart kurze Verbindungsleitungen sind infolge der hohen von bzw. zu diesen Leistungsbauelementen 23 fließenden Ströme anzustreben, weil die von diesen Strömen erzeugten elektromagnetischen Felder andere elektronische Bauelemente stören könnten und daher möglichst eng begrenzt werden müssen. Die erläuterte Anbindung des Schaltungsträgers 14 an das Gehäuse 11 erlaubt somit gleichzeitig zur Verbesserung der elektromagnetischen Leistungsfähigkeit eine Erhöhung der elektromagnetischen Verträglichkeit des Steuergeräts 10. Ein mit dem Gehäuse 11 verklebter Schaltungsträger 14 ist zudem auf vorhandenen Fertigungseinrichtungen ohne zusätzliche Umrüstmaßnahmen verarbeitbar, d.h. bestück- und lötbar.

Eine Weiterleitung der an die Grundplatte 15 abgeführten Wärmeenergie an die Flanschbauteile, an die das Steuergerät 10 im Einsatzfall angebaut ist, wird durch Befestigungslaschen 25 ermöglicht, die an den Rändern der Grundplatte 15 ausgebildet sind und die über die Begrenzungsfläche des Deckels 16 hinausragen. Diese Befestigungslaschen 25 können sich gemäß Figur 1 in der Ebene der Grundplatte 15 erstrecken, können aber auch in beliebigen Raumrichtungen abgekröpft dazu ausgebildet sein. Im Bereich der Befestigungslaschen 25 sind Durchgangsbohrungen 26 für Befestigungselemente ausgebildet, die neben der Befestigung des Steuergeräts 10 gleichzeitig die thermische Ankopplung an die Flanschbauteile gewährleistet.

In Figur 2 ist eine erste Ausführungsvariante zur Anbindung eines Leistungsbauelements 23 an den Schaltungsträger 14 einerseits und an die Grundplatte 15 des Gehäuses 11 andererseits im Längsschnitt dargestellt. Bei dieser ersten Variante sind in der wärmeableitenden Masse 24 als Abstandshalter wirkende Füllstoffe 28 enthalten. Diese Füllstoffe 28 halten das Leistungsbauelement 23 gegenüber der Grundplatte 15 des Gehäuses 11, wie auch gegenüber nicht gezeichneten benachbarten Bauelementen auf Abstand, so daß eine elektrische Isolation gewährleistet ist. Der Figur 2 ist zudem entnehmbar, daß der zwischen dem Leistungsbauelement 23 und dem Schaltungsträger 14 bestehende Spalt 29, in dem die elektrischen Kontaktierstellen 30 des Leistungsbauelements 23 erkennbar sind, mit einem zur wärmeableitenden Masse 24 unterschiedlichen Kapillarkleber 32 ausgefüllt ist. Dies bedingt zwei voneinander getrennte Arbeitsschritte zur Herstellung dieser Anbindung.

Wie Figur 3 zeigt, ist es auch durchaus möglich, bei der Anbindung des Leistungsbauelements 23 an die Grundplatte 15 bzw. an den Schaltungsträger 14 eine einheitliche wärmeableitende Masse 24a einzusetzen. Im Spalt 29 zwischen dem Schaltungsträger 14 und dem Leistungsbauelement 23, in dem dessen Kontaktierungsstellen 30 liegen, befindet sich demnach die selbe wärmeableitende Masse 24a, die auch die Wärmeübertragung vom Schaltungsträger 14 auf die Grundplatte 15 des Gehäuses 11 bewirkt, so daß der gemäß Figur 2 erläuterte zusätzliche Arbeitsschritt zur Aufbringung des Kapillarklebers 32 entfallen kann. Sollte desweiteren die elektrische Isolation des Leistungsbauelements 23 gegenüber seiner benachbarten Bauteilen ohne Belang sein, so können selbstverständlich auch preisgünstigere wärmeableitende Massen 24a ohne Füllstoffe 28 eingesetzt werden.

Figur 4 zeigt ein weiterentwickeltes Leistungbauelement 23a, das zur abermaligen Verbesserung der Abführung seiner Verlustwärme an das Gehäuse 11 mit einem Wärmeverteiler 34 gekoppelt ist. Die Wärmeverteiler 34 ist ein beliebig geformtes flächiges Bauteil, das aus einem gut wärmeleitenden Material, insbesondere aus Kupfer bzw. einer Kupferlegierung gefertigt ist. Der Wärmeverteiler 34 überragt das Leistungsbauelement 23a allseitig und ist vorzugsweise durch eine Lötung 35 mit der vom Schaltungsträger 14 abgewandten und potentialfreien Seite des Leistungsbauelements 23a verbunden. Die Lötung 35 kann im gleichen Lötprozeß erfolgen, in dem das Leistungsbauelement 23a mit dem Schaltungsträger 14 kontaktiert wird, kann jedoch auch als Konfektionierungsarbeitsgang vor dem Bestücken des Schaltungsträgers 14 durchgeführt werden. Die dem Leistungsbauelement 23a zur Verfügung stehende wärmeableitende Oberfläche wird durch den Wärmeverteiler 34 deutlich erhöht, ohne daß die Vorteile der Flip/Chip-Technik, wie beispielsweise der geringe Platzbedarf auf dem Schaltungsträger 14, der Entfall des Bondens bei der Herstellung der Leistungsbauelemente 23 oder dem vereinfachten Kontaktierungsprozeß derartiger Leistungsbauelemente 23 eingeschränkt werden. In seiner Materialdicke entspricht der Wärmeverteiler 34 exemplarisch der Dicke des Leistungsbauelements 23a, was zur Folge hat, daß die Dicke der wärmeableitenden Masse 24, in die das mit der Wärmeverteiler 34 ausgerüstete Leistungbauelement 23a eingebettet ist, im Bereich zwischen der Grundplatte 15 und dem Leistungsbauelement 23a nur unwesentlich reduziert wird. Die Einhaltung einer Mindestdicke für die wärmeableitende Masse 24 ist für deren automatische Aufbringung maßgeblich, da ansonsten die exakte Dosierung dieser Masse 24 nicht gewährleistet werden kann. Durch eine unterschiedliche Dicke der wärmeableitenden Masse 24 können Toleranzen und Maßunterschiede der Leistungsbauelemente 23 ausgeglichen werden.

Im Ausführungsbeispiel nach Figur 5 weist der in die wärmeableitende Masse 24 eingebettete Wärmeverteiler 34a an seinem das Leistungsbauelement 23b überragenden Enden Abkröpfungen 36 in Richtung des Schaltungsträgers 14 auf. Der Wärmeverteiler 34a überspannt damit die Leistungsbauelemente 23b brückenartig und stützt sich am Schaltungsträger 14 ab. Dabei wurde darauf geachtet, daß die Abkröpfungen 36 nicht mit auf dem Schaltungsträger 14 ausgebildeten Leitungsbahnen in Verbindung gelangen. Die Abkröpfungen 36 verhindern das Zusammendrücken der Kontaktierungsstellen 30 der Leistungsbauelemente 23b im Verlauf ihrer Kontaktierung mit dem Schaltungsträger 14 infolge der Gewichtskraft des Wärmeverteilers 34a, ohne jedoch das sich selbst Zentrieren der Leistungsbauelemente 23b bei dieser Kontaktierung zu behindern. Dünne und leichte Wärmeverteiler 34a bedürfen solchen Abkröpfungen 36 aus Gewichtsgründen nicht. Allerdings nehmen die Abkröpfungen 36 auch thermische und mechanische Belastungen der Leistungsbauelemente 23b und ihrer Kontaktierungsstellen 30 auf und können dadurch zur Erhöhung der mechanischen Beanspruchbarkeit des Gehäuses 11 herangezogen werden. Wärmeverteiler 34a können alternativ nach dem Kontaktierungsprozeß der Leistungsbauelemente 23b mit dem Schaltungsträger 14 auch durch eine Klebung 35a, beispielsweise mittels Silberleitklebern, wärmeleitend an den Leistungsbauelementen 23b befestigt werden. Dies bedingt zwar neben dem Lötvorgang einen zusätzlichen Klebearbeitsgang, hat aber den Vorteil, daß bei dicken Wärmeverteilern 34a die Kontaktierungsstellen 30 der Leistungsbauelemente 23b nicht belastet werden.

Das in Figur 6 dargestellte Steuergerät 10 ist im Hinblick auf eine zur Umgebung hin gerichtete Wärmeabführung verbessert. Zur Abführung der von den Leistungsbauelementen 23 erzeugten und mittels der wärmeableitenden Masse 24 an die Grundplatte 15 des Gehäuses 11 weitergeleiteten Wärmeenergie an die Umgebung ist an der Grundplatte 15 eine Wärmesenke in Form eines Kühlkörpers 33 angeordnet. Dieser Kühlkörper 33 ermöglicht die Ausbildung einer Luftkonvektion in der Umgebung des Steuergeräts 10. Figur 6 zeigt desweiteren eine an den Einsatzfall des Steuergeräts 10 angepaßte Steckeranordnung 18a zur Signalübertragung vom bzw. zum Schaltungsträger 14. Diese angepaßte Steckeranordnung 18a hat abgewinkelte Kontaktstifte 19a in einem entsprechend ausgebildeten Steckergehäuse 21a. Mit derartigen Steckeranordnungen 18a läßt sich das Steuergerät 10 bei geringem Platzbedarf einfacher mit seitlich zum Steuergerät 10 geführten Kabelsträngen verbinden.

Selbstverständlich sind Änderungen oder Ergänzungen am Ausführungsbeispiel möglich, ohne vom Grundgedanken der Erfindung abzuweichen.
So ist es beispielsweise möglich verschiedene Arten der Kühlung nebeneinander in einem Steuergerät 10 auszubilden. Beispielsweise könnten demnach die auf der einen Seite des Schaltungsträgers 14 angeordneten Leistungsbauelemente 23 erfindungsgemäß gekühlt werden, während die auf der gegenüberliegenden Seite des Schaltungsträgers 14 angeordneten Bauelemente 22 mittels einer aus dem Stand der Technik bekannten Methode gekühlt werden.
Schließlich ist es desweiteren auch denkbar, daß in einem Steuergerät 10 mehrere Schaltungsträger 14 vorhanden sind. In Bezug auf die Ausbildung der Wärmeverteiler 34 ist zu erwähnen, daß eine Wärmeverteiler 34 selbstverständlich auch mehrere Leistungsbauteile 23 überspannen kann.

## Patentansprüche

1. Steuergerät (10) mit einem zumindest zweiteiligen Gehäuse (11), in dessen Innenraum (12) wenigstens ein mit einer Steckeranordnung (18) verbundener Schaltungsträger (14) angeordnet ist, der mit elektrischen bzw. elektronischen Bauelementen (22, 23) bestückt ist, die mit einem ersten Kühlkörper zusammenwirken, dadurch gekennzeichnet, daß zumindest die Verlustwärme erzeugenden Bauteile (23) als integrierte Schaltkreise in Flip-Chip-Technik ausgebildet sind, daß der erste Kühlkörper ein aushärtender Wärmeleitkleber (24) ist, der die Verlustwärme erzeugenden Bauteile (23) allein oder zusammen mit anderen Massen (32) allseitig umschließt und daß der Schaltungsträger (14) mittels des Wärmeleitklebers (24) an wenigstens einem der Bauteile des Gehäuses (11) des Steuergeräts (10) fixiert ist.

2. Steuergerät nach Anspruch 1, dadurch gekennzeichnet, daß alle Verlustwärme erzeugenden Bauteile (23) auf der Seite des wenigstens einen Schaltungsträgers (14) plaziert sind, die dem Gehäuse (11) zugewandt ist.

3. Steuergerät nach einem der Ansprüche 1 oder 2, dadurch gekennzeichnet, daß der wenigstens eine Schaltungsträger (14) beidseitig mit elektronischen Bauelementen (22, 23) bestückt ist.

4. Steuergerät nach einem der Ansprüche 1 bis 3, dadurch gekennzeichnet, daß im Wärmeleitkleber (24) Füllstoffe (28) enthalten sind, die als Abstandshalter zwischen den Verlustwärme erzeugenden Bauteilen (23) und dem Gehäuse (11) wirken.

5. Steuergerät nach einem der Ansprüche 1 bis 4, dadurch gekennzeichnet, daß der Abstand zwischen den Verlustwärme erzeugenden Bauelementen (23) und dem Gehäuse (11) oder zwischen den Verlustwärme erzeugenden Bauelementen (23) untereinander mindestens so groß ist, daß er wenigstens eine Lage an Füllstoffen (28) aufnimmt.

6. Steuergerät nach einem der Ansprüche 1 bis 5, dadurch gekennzeichnet, daß der Wärmeleitkleber (24) zumindest eine der mit elektronischen Bauteilen bestückten Flächen des wenigstens einen Schaltungsträgers (14) überdeckt.

7. Steuergerät nach einem der Ansprüche 1 bis 6, dadurch gekennzeichnet, daß die Verlustwärme erzeugenden Bauelemente (23) mit wenigstens einem Wärmeverteiler (34) zusammenwirken, der gemeinsam mit den Bauelementen (23) in den Wärmeleitkleber (24) eingebettet ist und der die wärmeabgebende Oberfläche der Bauelemente (23) vergrößert.

8. Steuergerät nach Anspruch 7, dadurch gekennzeichnet, daß der Wärmeverteiler (34) aus einem metallischen, insbesondere einem kupferhaltigen Stoff mit guten Wärmeleiteigenschaften besteht, und mit den von dem Schaltungsträger (14) abgewandten Seiten der Bauelemente (23) durch eine Lötung (35) oder eine Klebung (35a) verbunden ist.

9. Steuergerät nach einem der Ansprüche 7 oder 8, dadurch gekennzeichnet, daß der Wärmeverteiler (34) flächig ausgebildet ist und wenigstens eine Abkröpfung (36) aufweist, mit der sich der Wärmeverteiler (34) am Schaltungsträger (14) abstützt.

10. Steuergerät nach einem der Ansprüche 1 bis 9, dadurch gekennzeichnet, daß auf der Außenseite des Gehäuses (11) wenigstens ein zweiter Kühlkörper (33) angeordnet ist.

11. Steuergerät nach Anspruch 10, dadurch gekennzeichnet, daß der wenigstens eine zweite Kühlkörper (33) auf der den Verlustwärme erzeugenden Bauteilen (23) zugewandten Seite des Gehäuses (11) angeordnet ist.

## Claims

1. Controller (10) having a housing (11) composed of at least two parts, in whose interior (12) at least one circuit base (14) is arranged, which is connected to a connector arrangement (18) and is fitted with electrical and/or electronic components (22, 23) which interact with a first heat sink, characterized in that at least those components (23) which produce heat losses are in the form of integrated circuits using flip-chip technology, in that the first heat sink is a curing thermally conductive adhesive (24) which encloses those components (23) which produce heat losses on all sides on their own or together with other compounds (32), and in that the circuit base (14) is fixed by means of the thermally conductive adhesive (24) to at least one of the components of the housing (11) of the controller (10).

2. Controller according to Claim 1, characterized in that all the components (23) which produce heat losses are placed on that side of the at least one circuit base (44) which faces the housing (11).

3. Controller according to one of Claims 1 or 2, characterized in that the at least one circuit base (14) is fitted with electronic components (22, 23) on both sides.

4. Controller according to one of Claims 1 to 3, characterized in that the thermally conductive adhesive (24) contains fillers (28) which act as spacers between the housing (11) and those components (23) which produce heat losses.

5. Controller according to one of Claims 1 to 4, characterized in that the distance between the housing (11) and those components (23) which produce heat losses, or in between those components (23) which produce heat losses is at least sufficiently large to accommodate at least one layer of fillers (28).

6. Controller according to one of Claims 1 to 5, characterized in that the thermal conductive adhesive (24) covers at least one of those surfaces of the at least one circuit base (14) which are fitted with electronic components.

7. Controller according to one of Claims 1 to 6, characterized in that those components (23) which produce heat losses interact with at least one heat distributor (34), which is embedded together with the components (23) in the thermally conductive adhesive (24) and which enlarges the heat-emitting surface area of the components (23).

8. Controller according to Claim 7, characterized in that the heat distributor (34) is composed of a metallic material, in particular a material containing copper, having good thermal conduction characteristics, and is connected by soldering (35) or bonding (35a) to those sides of the components (23) which face away from the circuit base (14).

9. Controller according to one of Claims 7 or 8, characterized in that the heat distributor (34) is of planar form and has at least one bend (36) by means of which the heat distributor (34) is supported on the circuit base (14).

10. Controller according to one of Claims 1 to 9, characterized in that at least one second heat sink (33) is arranged on the outside of the housing (11).

11. Controller according to Claim 10, characterized in that the at least one second heat sink (33) is arranged on that side of the housing (11) which faces those components (23) which produce heat losses.

## Revendications

1. Appareil de commande (10) comportant un boîtier (11) au moins en deux parties dont le volume intérieur (12) reçoit au moins un support de circuit (14) relié au dispositif de connexion (18), ce support étant garni de composants électriques ou électroniques (22, 23) coopérant avec un premier radiateur,
caractérisé en ce qu'
- au moins les composants (23) dégageant de la chaleur sont réalisés sous la forme de circuits intégrés en technique Flip/Chip,
- le premier radiateur est une colle conductrice de chaleur (24), durcie, qui entoure les composants (23) dégageant de la chaleur, seule ou avec d'autres masses (32) sur toutes les faces et
- le support de circuit (14) est fixé à l'aide de colle conductrice de chaleur (24) sur au moins l'un des composants du boîtier (11) de l'appareil de commande (10).

2. Appareil de commande selon la revendication 1,
caractérisé en ce que
tous les composants (23) dégageant de la chaleur sont disposés sur un côté tourné vers le boîtier (11) d'au moins un support de circuit (14).

3. Appareil de commande selon l'une des revendications 1 ou 2,
caractérisé en ce qu'
au moins un support de circuit (14) est garni de composants électroniques (22, 23) sur ses deux faces.

4. Appareil de commande selon l'une des revendications 1 à 3,
caractérisé en ce que
la colle conductrice de chaleur (24) contient des matières de remplissage (28) qui fonctionnent comme des organes d'écartement entre les composants (23) dégageant de la chaleur et le boîtier (11).

5. Appareil de commande selon l'une des revendications 1 à 4,
caractérisé en ce que
la distance entre les composants (23) dégageant de la chaleur et le boîtier (11) ou entre les composants (23) dégageant de la chaleur, entre eux, est au moins suffisante pour recevoir au moins une couche de matière de remplissage (28).

6. Appareil de commande selon l'une des revendications 1 à 5,
caractérisé en ce que
la colle conductrice de chaleur (24) recouvre au moins une des surfaces d'au moins un support de circuit (14) garni de composants électroniques.

7. Appareil de commande selon l'une des revendications 1 à 6,
caractérisé en ce que
les composants (23) dégageant de la chaleur coopèrent avec au moins un répartiteur de chaleur (34) qui est intégré en commun avec les composants (23) dans la colle conductrice de chaleur (24) et qui augmente la surface du composant (23) dégageant la chaleur.

8. Appareil selon la revendication 7,
caractérisé en ce que
le répartiteur de chaleur (34) est formé d'une matière métallique, notamment contenant du cuivre, ayant de bonnes propriétés de conduction thermique et est relié avec le côté du composant (23) non tourné vers le support de circuit (14) par une soudure (35) ou une liaison collée (35a).

9. Appareil de commande selon l'une des revendications 7 ou 8,
caractérisé en ce que
le répartiteur de chaleur (34) est déployé en surface et comporte au moins une partie recourbée (36) par laquelle il s'appuie contre le support de circuit (14).

10. Appareil de commande selon l'une des revendications 1 à 9,
caractérisé en ce que
le côté extérieur du boîtier (11) comporte au moins un second radiateur (33).

11. Appareil selon la revendication 10,
caractérisé en ce qu'
au moins un second radiateur (33) est prévu sur le côté du boîtier (11) tourné vers les composants (23) dégageant de la chaleur.
